# EUROPEAN PATENT APPLICATION

(11) **EP 2 975 612 A1**
(43) Date of publication of application: **20.01.2016**
(21) Application number: 14763893.6
(22) Date of filing: 12.03.2014
(51) Int. Cl.: G11B 33/08, F16C 29/04, F16F 15/08, G11B 33/12, H05K 7/14, H05K 7/18

(54) **ELECTRONIC DEVICE CASE STRUCTURE**

(30) Priority: 12.03.2013 JP 2013048952
(71) Applicant: NEC Platforms, Ltd., Kanagawa 213-8511 (JP)
(72) Inventor: NAKANO Hideki, Kawasaki-shi Kanagawa 2138511 (JP)
(74) Representative: Vossius & Partner Patentanwälte Rechtsanwälte mbB
(86) International application number: PCT/JP2014/056471
(87) International publication number: WO 2014/142164

(57) **Abstract**

To provide an electronic device case structure which suppresses noise generation caused by vibrations generated from electronic devices held inside an electronic device unit being propagated to a unit case.

An electronic device case structure (10) provided with a unit case (11) which is detachably mounted to an electronic device unit (30) that holds electronic devices (35) therein, said electronic devices (35) being vibration generating sources. The unit case (11) is provided with unit support mechanisms (18) which comprise rotatable roller members (19) that guide and support the electronic device unit (30) when the electronic device unit (30) is being attached or detached. The roller members (19) are configured from vibration-preventing members that comprise an elastic material.

## Description

### [Technical Field]

The present invention relates to an electronic device case structure which suppresses noise generation caused by propagation of vibration from vibration generating sources such as an HDD (Hard Disk Drive) and other disk drive devices to a unit case as an electronic device unit which holds the vibration generating sources is mounted in the unit case.

### [Background Art]

In general, an electronic device such as a server includes movable units such as an HDD, a disk drive device, or a cooling fan. These movable units act as vibration generating sources.

Vibration generated by such vibration generating sources propagates to each unit of a unit case and acts as noise generating sources, as an electronic device unit which holds the electronic device is mounted in the unit case.

Especially noise generated when the HDD acts as a vibration generating source grates on human's ears because of its constant frequency, thus making the users feel uncomfortable. In highly silent products, the ratio of noise due to vibration of the HDD to the total noise is relatively high.

When a plurality of HDDs are mounted, interference between vibration forces generated by the HDDs may produce beat waveforms due to slight differences in frequency between the HDDs, which grate on human's ears as noise. The users often make complaints about this problem, against which a countermeasure is required.

Examples of effective solutions to this problem include preventing vibration generated by the vibration generating sources from propagating to each unit of the unit case that may act as a noise emitting source.

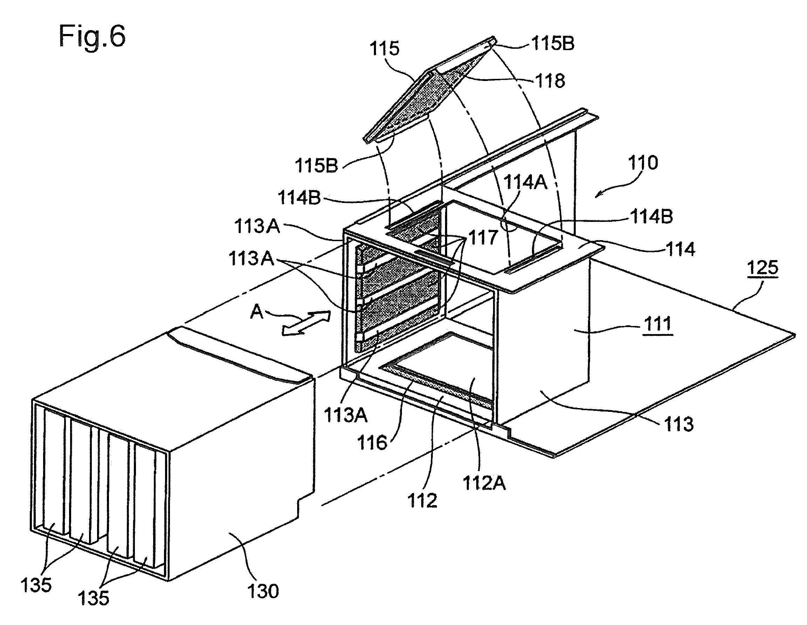

The known conventional examples include an electronic device case structure 110 having a structure which prevents vibration propagation, as shown in Fig. 6.

More specifically, an electronic device unit 130 which holds an electronic device includes four vibration generating sources 135 (for example, HDDs). The electronic device unit 130 is, for example, movable in a direction indicated by an arrow A (direction of attachment and detachment) relative to a unit case 111 of a tower server device 125 and can be easily attached to and detached from the unit case 111.

The unit case 111 has a quadrangular frame-shaped cross-section defined by a bottom surface portion 112, side surface portions 113, and a top surface portion 114. The bottom surface portion 112 includes a plate 112A. The bottom surface of the electronic device unit 130 abuts against the top surface of the plate 112A and is slidable on this top surface.

Three guide rails 113A are arranged on each of the opposed inner surface portions of the side surface portions 113 to vertically align themselves and extend in the direction indicated by the arrow A.

An opening portion 114A is formed in the top surface portion 114 of the unit case 111. A unit holding member 115 is detachably provided to seal the opening portion 114A. Engagement portions 115B are formed at the two ends of the unit holding member 115 in a direction perpendicular to the direction of attachment and detachment A by bending.

In contrast to this, engagement holes 114B which engage with the engagement portions 115B of the unit holding member 115 are formed in the top surface portion 114 of the unit case 111.

A sheet-like low-elasticity material 116 surrounds the plate 112A of the bottom surface portion 112. Sheet-like low-elasticity materials 117 are arranged between adjacent guide rails of the three guide rails 113A and outside the two, uppermost and lowermost guide rails 113A. A sheet-like low-elasticity material 118 is placed on the back surface of the unit holding member 115.

Independently of the above-mentioned electronic device case structure, a housing device for an acoustic device is known (see PTL 1).

The housing device for an acoustic device disclosed in PTL 1 includes a plurality of rollers which are formed by elastic members and arranged on four faces of a box-shaped sleeve. With this arrangement, an acoustic device can be easily housed in and removed from the sleeve. Since the acoustic device is pressed by the elasticity of the rollers, vibration of the housing is suppressed and vibration externally applied to the sleeve is blocked.

Examples of other known devices which prevent vibration include a drawer device (see PTL 2).

In the drawer device disclosed in PTL 2, rollers are rotatably attached to helical coil insert nuts for bolts at the lower end portions of the side walls of the housing, which mount a video tape recorder accommodated in an accommodation unit on a mounting table and pull it out. The mounting table is slid and pulled out so as to clamp the rollers by slider fittings at the two ends of the mounting table.

In, for example, accommodation of an MD (MiniDisc) device, a housing device for an acoustic device which presses an MD device inserted in a sleeve by the elasticity of rollers is also known (see PTL 3).

### [Citation List]

### [Patent Literature]

[PTL 1] Japanese Patent No. 3980359
[PTL 2] Japanese Unexamined Patent Application Publication No. 2002-305048
[PTL 3] Japanese Unexamined Patent Application Publication No. H09-191186

### [Summary of Invention]

### [Technical Problem]

However, the above-mentioned conventional examples respectively pose the following problems. That is, in the electronic device case structure 110 shown in Fig. 6, the electronic device unit 130 comes into contact with the plate 112A and guide rails 113A of the unit case 111 and is detachably slid. Hence, the unit case 111 is not in direct contact with the low-elasticity material 116 in the bottom surface portion 112 and the low-elasticity materials 117 between adjacent guide rails of the guide rails 113A in the side surface portions.

In the above-mentioned arrangement, vibration generated upon driving of the HDDs held in the electronic device unit 130 directly propagates not to the low-elasticity materials 116 and 117 but to the unit case 111. Therefore, an unsatisfactory anti-vibration effect is produced, making it impossible to sufficiently suppress noise generation by the case.

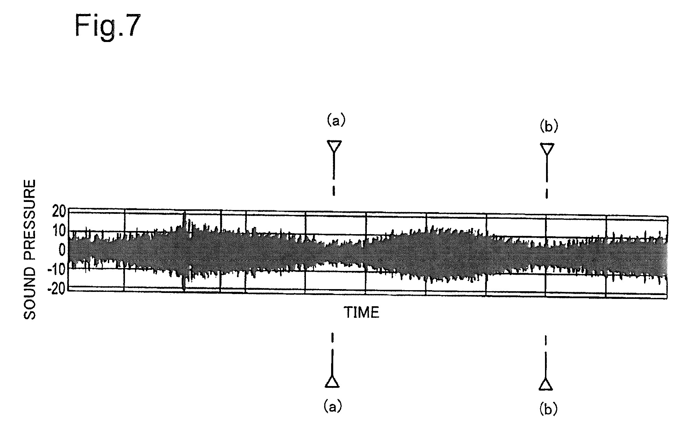

Fig. 7 shows a temporal change in sound pressure in the vibration propagation preventing structure 110 according to this conventional example. The temporal change in sound pressure is obtained as a result of sound pressure measurement by a microphone.

As can be seen from the measurement result shown in Fig. 7, in this example, noise is generated because the amplitude of natural vibration is large and vibration transmitted to the unit case 111, in turn, is large.

In the housing device for an acoustic device disclosed in PTL 1, an acoustic device can, indeed, be easily housed in and removed from the sleeve. Further, in this housing device, since the acoustic device is pressed by the elasticity of the rollers, vibration of the housing is suppressed and vibration externally applied to the sleeve is blocked.

Note, however, that the above-mentioned housing device for an acoustic device is used for an MD device. The MD device is low in height and the housing device for an acoustic device is also low in height. Therefore, when a housing device having such a configuration is designed to be capable of holding even a plurality of (for example, four) high-height products such as HDDs, rollers having a large total length are required. In addition, since the weight of the rollers is heavy, the weight of the housing for an acoustic device is also heavy.

When long, heavy rollers are attached and any of them breaks down for some reason, the roller in question requires individual replacement, resulting in poor efficiency.

In the drawer device disclosed in PTL 2, the rollers are rotatably attached to the helical coil insert nuts for the bolts at the lower end portions of the side walls of the housing. However, these rollers are intended to slide the slider fittings and not intended to suppress propagation of vibration generated by the vibration generating sources held in the electronic device unit.

The housing device for an acoustic device disclosed in PTL 3 also has the same problem as in PTL 1.

### [Objective of Invention]

It is an exemplary object of the present invention to provide an electronic device case structure which suppresses noise generation caused by propagation of vibration generated by an electronic device held in an electronic device unit to a unit case.

### [Solution to Problem]

An electronic device case structure according to the present invention includes a unit case detachably mounted with an electronic device unit which holds inside, an electronic device acting as a vibration generating source, and a unit support mechanism including a plurality of roller members implemented in a vibration-preventing member made of an elastic material, the roller members supporting the electronic device unit and guiding the electronic device unit in attaching and detaching the electronic device unit.

### [Advantageous Effects of Invention]

With the electronic device case structure according to the present invention, since an electronic device unit which holds inside, an electronic device acting as a vibration generating source is supported by a unit case through a unit support mechanism including roller members, the electronic device unit and the unit case are supported by a floating structure without being in direct contact with each other. Since the roller members are implemented in a vibration-preventing member made of an elastic material, propagation of vibration generated by the electronic device acting as a vibration generating source is suppressed. Therefore, it is possible to prevent vibration generated by the electronic device from propagating to the unit case and radiating from the unit case as sound waves to suppress noise generation.

Since the electronic device unit is guided by the roller members in attaching and detaching the electronic device unit to and from the unit case, attachment and detachment can easily be done.

Since the roller members are implemented in a vibration-preventing member and rotate in attaching and detaching the electronic device unit, it is possible to prevent the vibration-preventing member that is made of a low-elasticity material from greatly deforming by a shearing force to, in turn, prevent degradation in performance of the vibration-preventing member.

### [Brief Description of Drawings]

[Fig. 1] Fig. 1 is an exploded perspective view illustrating an exemplary embodiment of an electronic device case structure according to the present invention.
[Fig. 2] Fig. 2 is a front view showing an electronic device unit according to the exemplary embodiment as mounted in a unit case when only the unit case is represented in a cross-sectional view.
[Fig. 3] Fig. 3 is a side view showing the electronic device unit according to the exemplary embodiment as mounted in the unit case when only the unit case is represented in a cross-sectional view in the direction of attachment and detachment.
[Fig. 4] Fig. 4 is an overall perspective view showing details of a unit support mechanism including a roller member according to the exemplary embodiment.
[Fig. 5] Fig. 5 is a chart illustrating an exemplary result of measuring, by a microphone, the sound pressure of vibration transmitted from a vibration generating source in the electronic device unit to the unit case in the case structure according to the exemplary embodiment.
[Fig. 6] Fig. 6 is an overall perspective view showing the conventional electronic device case structure.
[Fig. 7] Fig. 7 is a chart illustrating an exemplary result of measuring, by a microphone, the sound pressure of vibration transmitted from the vibration generating source in the electronic device unit to the unit case in the conventional electronic device case structure.

### [Description of Embodiments]

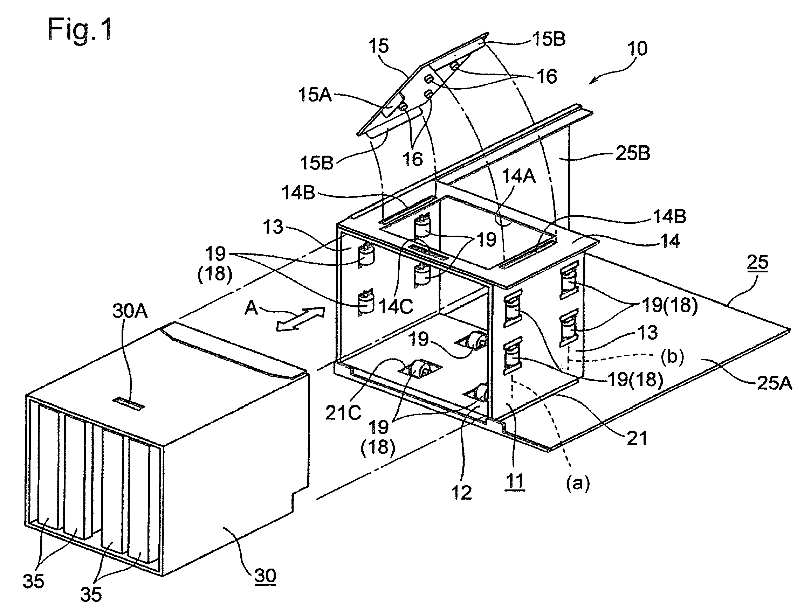

An exemplary embodiment of an electronic device case structure according to the present invention will be described below with reference to Figs. 1 to 4.

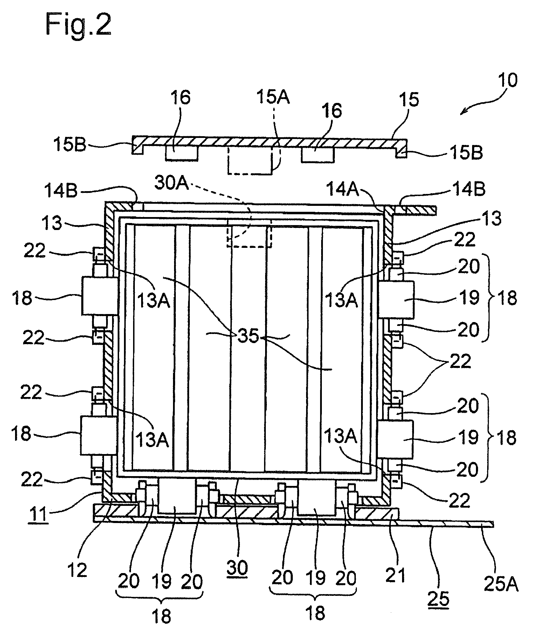

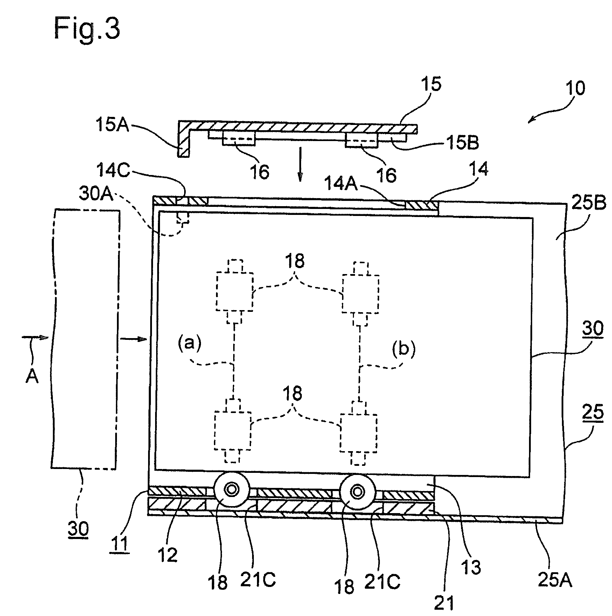

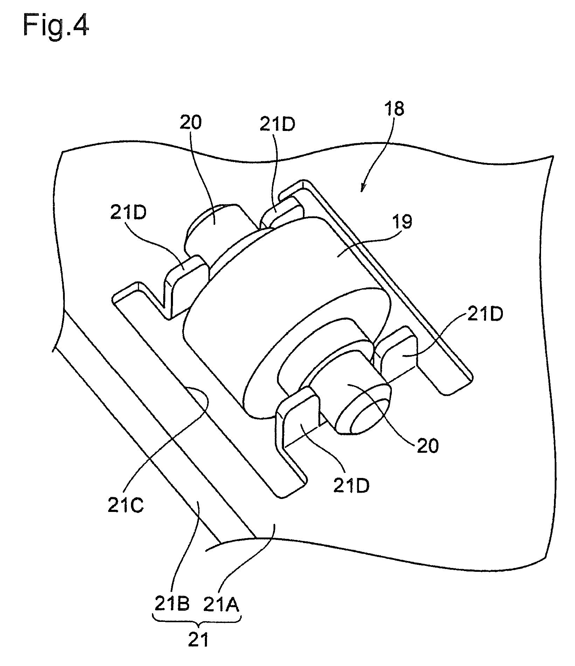

Fig. 1 is an overall perspective view illustrating an electronic device case structure 10. Fig. 2 is a front view showing an electronic device unit (to be simply referred to as a unit hereinafter) 30 which holds an electronic device as mounted in a unit case 11. Fig. 3 is a side view showing the unit 30 as mounted in the unit case 11 in a cross-section taken in the direction of attachment and detachment. Fig. 4 is an overall perspective view showing a unit support mechanism 18 including a rotatable roller member 19.

The electronic device case structure 10 according to this exemplary embodiment includes a unit case 11 detachably mounted with the unit 30 that holds inside, electronic devices such as HDDs 35, as described above, acting as vibration generating sources.

The unit case 11 includes, in a plurality of areas, unit support mechanisms 18 which support the unit 30 and guide the unit 30 in its attachment and detachment. The unit support mechanisms 18 include rotatable roller members 19. The roller members 19 are implemented in a vibration-preventing member made of an elastic material, especially a low-elasticity material.

The unit 30 is made of a steel plate or hard plastic and has a quadrangular box shape. The unit 30 includes an accommodation room separated by partitions (not illustrated). A plurality of (in this exemplary embodiment, four) HDDs 35 are exchangeably accommodated in the accommodation room.

The unit 30 as mentioned above is attached to, for example, a tower server device 25 including the unit case 11.

The unit 30 is moved toward the unit case 11 in the direction of attachment and detachment indicated by an arrow A in Fig. 1 so as to be detachably attached to the unit case 11.

An engagement hole 30A which engages with a locking portion 15A formed in a holding member 15 (to be described in detail later) is formed in the top surface of the unit 30 on the side of an insertion opening of the HDDs 35.

The unit case 11 is also made of a steel plate or hard plastic and has a quadrangular frame-shaped cross-section to allow it to receive the unit 30. The unit case 11 is fixed to a bottom plate 25A and side plate 25B of the main body portion of the tower server device 25.

The unit 30 is supported inside the unit case 11 in a nearly floated state through the roller members 19 of the unit support mechanisms 18, as shown in Fig. 2.

More specifically, the unit support mechanisms 18 include a plurality of (in this exemplary embodiment, four) rotatable roller members 19 arranged in each of a bottom surface portion 12 and opposed side surface portions 13 of the unit case 11.

With this arrangement, the unit 30 is supported, while the outer peripheral surfaces of the respective roller members 19 are kept in direct contact with the outer peripheral surfaces of three out of four faces of the unit 30, that is, in a floated state.

Two unit support mechanisms 18 each including the roller member 19 are arranged in the bottom surface portion 12 of the unit case 11 on each of two lines, that is, the front and back sides in the direction of attachment and detachment A.

Two unit support mechanisms 18 each including the roller member 19 are also arranged in each of the opposed side surface portions 13 of the unit case 11 on each of two lines, that is, the front and back sides in the direction of attachment and detachment A.

The unit support mechanisms 18 are arranged on the front and back sides in the direction of attachment and detachment A with spacings between them nearly equal in the bottom surface portion 12 and the side surface portions 13.

As described above, the unit 30 is supported using a plurality of (in this exemplary embodiment, a total of 12) roller members 19 of the unit support mechanisms 18 as support points.

In the electronic device unit 30, the unit case 11 can be effectively insulated against vibration by supporting the areas (nodes of vibration) where the amplitude of natural vibration generated by vibration generating sources such as HDDs is minimal.

In this exemplary embodiment, two roller members 19 of the unit support mechanisms 18 are arranged in each of the bottom surface portion 12 and side surface portions 13 of the unit case 11, in correspondence with the position of each of areas (a) and (b) where the amplitude of natural vibration obtained by sound pressure measurement shown in Fig. 7 in the conventional structure is minimal, that is, the position of each node of vibration.

This state is represented by (a) and (b) respectively indicating the front and back roller members 19, as illustrated in Figs. 1 and 3.

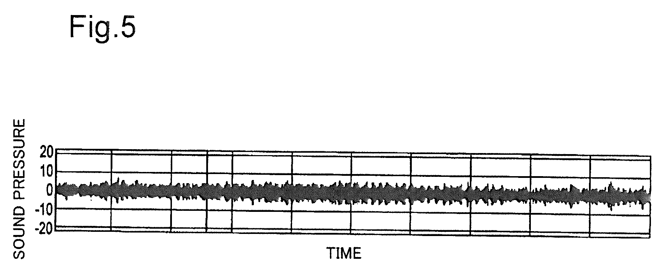

Fig. 5 is a chart illustrating an exemplary vibration measurement result obtained by sound pressure measurement using a microphone. In this measurement, four HDDs were mounted as vibration generating sources.

As described above, when the two roller members 19 of the unit support mechanisms 18 on each of the front and back sides are arranged at the positions of areas (a) and (b) having nodes of vibration, a great noise reduction effect could be obtained, as illustrated in Fig. 5.

In this case, the rotational speed of the HDDs is 15000 rpm (rotation per minute). The main frequency of vibration generated by the rotation of the HDDs is 250 Hz (= 15000/60). To focus attention on sounds generated by the HDDs, a sound wave in a waveband having a center frequency of 250 Hz was extracted by band-pass filtering.

As shown in Figs. 2 and 4, each unit support mechanism 18 arranged in the bottom surface portion 12 includes a rotatable roller member 19 and shaft members 20 which support the roller member 19. The roller member 19 is made of rubber or an elastomer that is a low-elasticity material. The shaft members 20 are made of a metal or hard plastic.

The shaft members 20 of the unit support mechanisms 18 having the above-mentioned configuration are rotatably supported by a support plate 21. The support plate 21 is mounted on the top surface of the bottom plate 25A of the tower server device 25 while being laid below the bottom surface portion 12 of the unit case 11, as shown in Fig. 1.

The support plate 21 has an inverted tray configuration defined by a top surface portion 21 A and an edge portion 21 B which is formed below the top surface portion 21A and has a predetermined height, as shown in Fig. 4.

An opening portion 21C is formed at a predetermined position in the top surface portion 21 A to rotatably mount the roller member 19 of the unit support mechanism 18.

Bifurcated shaft support portions 21D which horizontally support the shaft members 20 of the unit support mechanism 18 are formed on an edge portion defining the opening portion 21C to stand upright from the top surface portion 21A.

The shaft support portions 21D are arranged with a predetermined spacing between them in a direction perpendicular to the direction of attachment and detachment A to enable the roller member 19 to rotate in the direction of attachment and detachment A.

Two sets of unit support mechanisms 18 like that shown in Fig. 4 are also arranged in the side surface portions 13, respectively.

The unit support mechanisms 18 arranged in the bottom surface portion 12 are different from the sets of unit support mechanisms 18 arranged in the side surface portions 13 in terms of positions where the unit support mechanisms 18 are attached and features of a support unit which rotatably supports the shaft members 20.

More specifically, opening portions 13A (see Fig. 2) are formed at predetermined positions in the side surface portions 13 to rotatably mount the unit support mechanisms 18.

The unit support mechanisms 18 are arranged in each of the side surface portions 13 so that the shaft members 20 at the two ends of each unit support mechanism 18 extend vertically. With this arrangement, the roller members 19 can rotate about the vertical axis.

The unit support mechanisms 18 are attached to the side surface portions 13 by holding the outer peripheries of the shaft members 20 of the unit support mechanisms 18 using shaft support members 22 such as commonly-used U bands while the shaft members 20 abut against the outer surfaces of the side surface portions 13, as shown in Fig. 2.

In doing this, the side surface portions 13 that abut against the lower surfaces of the lower shaft members 20, of the upper and lower shaft members 20 of the vertically aligned unit support mechanisms 18, at given positions bear the loads of the unit support mechanisms 18. Therefore, shaft receptacles (not illustrated) are placed at these positions of the side surface portions 13.

As described above, when the unit 30 is attached to the unit case 11, the unit support mechanisms 18 respectively arranged in the side surface portions 13 of the unit case 11 are supported by the shaft support members 22 so that the outer peripheral surface of the unit 30 slightly presses the outer circumferential surfaces of the respective roller members 19 of the unit support mechanisms 18.

With this arrangement, as shown in Fig. 2, the unit 30 is supported by the roller members 19 of the unit support mechanisms 18 arranged in each of the bottom surface portion 12 and side surface portions 13 of the unit case 11 and is attached to the unit case 11 in a nearly floated state, as described earlier.

As shown in Figs. 1 to 3, an opening portion 14A is formed in a top surface portion 14 of the unit case 11, and the unit holding member 15 that also serves as a lid is removably placed in the opening portion 14A.

The unit holding member 15 has a nearly quadrangular shape, and a locking portion 15A shaped by being bent to have an L-shaped cross-section is formed in the front surface portion of the unit case 11 in the direction of attachment and detachment A.

The locking portion 15A engages with an engagement hole 30A, as described above, formed in the top surface of the unit 30, upon being inserted into a through hole 14C formed in the top surface portion 14 of the unit case 11 when the unit 30 is attached to the unit case 11.

With this arrangement, engaging the locking portion 15A with the engagement hole 30A makes it possible to prevent the unit 30 mounted in the unit case 11 from slipping in the direction of attachment and detachment A.

A plurality of (in this exemplary embodiment, four) pressing members 16 are arranged on the back surface of the unit holding member 15 and capable of pressing the top surface of the unit 30. The pressing members 16 are opposed to the unit support mechanisms 18 arranged in the bottom surface portion 12 of the unit case 11.

The pressing members 16 are made of rubber or an elastomer, as in the roller members 19 of the unit support mechanisms 18, and have, for example, a cylindrical shape. The pressing members 16 can press and support the top surface of the unit 30 attached to the unit case 11, by a predetermined pressure.

Engagement portions 15B for attachment, having inverted L-shaped cross-sections are formed at the two ends of the unit holding member 15 in a direction perpendicular to the locking portion 15A of the unit holding member 15.

In contrast to this, engagement holes 14B which engage with the engagement portions 15B are formed in the top surface portion 14 of the unit case 11. With this arrangement, when the unit 30 is attached to the unit case 11 and the top surface portion 14 of the unit case 11 is covered with the unit holding member 15, the locking portion 15A engages with the engagement hole 30A and the engagement portions 15B engage with the engagement holes 14B.

An operation of attaching or detaching the unit 30, as described above, to or from the unit case 11 is performed in the following way.

First, in attachment, the user removes the unit holding member 15 of the unit case 11. The user then moves the unit 30 holding the HDDs 35 in the direction of attachment and detachment A to insert the unit 30 into the unit case 11.

In doing this, the user inserts the unit 30 into the unit case 11 while checking the position of the unit 30 so that the outer peripheral bottom surface and outer peripheral side surfaces of the unit 30 are slightly pressed by the outer peripheral surfaces of the roller members 19 of the unit support mechanisms 18 arranged in the bottom surface portion 12 and the side surface portions 13.

When the unit 30 has been inserted up to a predetermined stop position, the user sets the unit holding member 15 at a position above the opening portion 14A of the unit case 11. The user inserts the locking portion 15A of the unit holding member 15 into the through hole 14C in the top surface portion 14 of the unit case 11 and engages the locking portion 15A with the engagement hole 30A of the unit 30. At the same time, the user engages the engagement portions 15B of the unit holding member 15 with the engagement holes 14B in the top surface portion 14 of the unit case 11.

In detaching the unit 30 from the unit case 11, the user need only execute the procedure reverse to the above-mentioned procedure of attachment.

More specifically, first, the user lifts the unit holding member 15 to the upper side to cancel both the engagement between the locking portion 15A of the unit holding member 15 and the engagement hole 30A of the unit 30 and the engagement between the engagement portions 15B of the unit holding member 15 and the engagement holes 14B in the top surface portion 14 of the unit case 11.

The user need only pull the unit 30 out of the unit case 11 in the direction of attachment and detachment A. In doing this, the unit 30 moves along the roller members 19 of the unit support mechanisms 18 held on three faces, namely, the bottom surface portion 12 and side surface portions 13 of the unit case 11. This makes it easy for the user to pull out the unit 30.

The use of the electronic device case structure 10 according to this exemplary embodiment produces the following effects.
(1) A unit 30 which holds inside, the HDDs 35 acting as vibration generating sources is supported by the unit case 11 through the unit support mechanisms 18 including the roller members 19. With this arrangement, the unit 30 is supported by a floating structure without being in direct contact with the unit case 11. Since the roller members 19 are implemented in a vibration-preventing member made of a low-elasticity material, propagation of vibration generated by the HDDs 35 acting as vibration generating sources to the unit case 11 is suppressed. It is, therefore, possible to prevent vibration generated by the HDDs 35 from propagating to the unit case 11 and radiating from the unit case 11 as sound waves to suppress noise generation.
(2) The unit 30 can be easily attached to and detached from the unit case 11 because the unit 30 is guided by the roller members 19 in its attachment and detachment.
(3) The roller members 19 are implemented in a vibration-preventing member made of rubber or an elastomer that is a low-elasticity material and rotate in attaching and detaching the unit 30. It is, therefore, possible to prevent the vibration-preventing member made of a low-elasticity material from greatly deforming by a shearing force to, in turn, prevent degradation in performance of the vibration-preventing member.
(4) Four pressing members 16 which press the top surface of the unit 30 are arranged on the back surface of the unit holding member 15. The pressing members 16 are positioned in correspondence with the four roller members 19 arranged in the bottom surface portion 12 of the unit case 11. Therefore, the pressing members 16 can press the unit 30 with good balance and also serve to suppress propagation of vibration to the unit case 11.
(5) A locking portion 15A shaped by being bent to have an L-shaped cross-section is formed in the front surface portion of the unit holding member 15 of the unit case 11 in the direction of attachment and detachment A. The locking portion 15A can engage with the engagement hole 30A formed in the top surface of the unit 30. Therefore, engaging the locking portion 15A with the engagement hole 30A makes it possible to prevent the unit 30 mounted in the unit case 11 from slipping in the direction of attachment and detachment A.
(6) Two roller members 19 are arranged on each of the front and back sides, in the direction of attachment and detachment A, of each of the bottom surface portion 12 and opposed side surface portions 13 of the unit case 11. The roller members 19 are formed large enough to support and guide the unit 30. This obviates the need to use long rollers, unlike those described in the conventional example, thus achieving a lightweight configuration.
(7) Two roller members 19 are arranged on each of the front and back sides, in the direction of attachment and detachment A, of each of the bottom surface portion 12 and opposed side surface portions 13 of the unit case 11. Therefore, even if any of the roller members 19 breaks down for some reason, the broken roller member need only be replaced with a new one and this prevents any serious obstacle to the operations.
(8) As described with reference to Fig. 5, the electronic device case structure 10 according to this exemplary embodiment can produce a great noise reduction effect, as is apparent from the information obtained by sound pressure measurement using a microphone.

Although the present invention has been described above with reference to an exemplary embodiment, the present invention is not limited to the above-described exemplary embodiment. Various changes that would be understood by those skilled in the art can be made to the configurations and details of the present invention. The present invention also incorporates appropriate combinations of some or all of the configurations of the above-described exemplary embodiment.

For example, a locking portion 15A shaped by being bent to have an L-shaped cross-section is formed in the front surface portion of the unit holding member 15 of the unit case 11 in the direction of attachment and detachment A. The locking portion 15A engages with the engagement hole 30A formed in the top surface of the unit 30. However, the configuration of the locking portion 15A is not limited to this. The locking portion 15A may be formed not only in the front surface portion of the unit holding member 15 in the direction of attachment and detachment A but also on the back side, and an engagement hole which engages with the locking portion may be formed on the back side of the top surface of the unit 30 in correspondence with the locking portion 15A, so that locking portions and engagement holes are formed in the two, front and back areas in the direction of attachment and detachment A. This makes it possible to more reliably lock the unit 30 using the two, front and back areas in the direction of attachment and detachment.

Although the engagement portions 15B are formed at the two ends of the unit holding member 15 in a direction perpendicular to the direction of attachment and detachment A to fit into the top surface portion 14 of the unit case 11, the present invention is not limited to this. Engagement portions may be formed at, for example, the two ends of the unit holding member 15 in the direction of attachment and detachment A.

In this case, the front engagement portion in the direction of attachment and detachment A can also be used as a locking portion by being formed to have the same shape and size as those of the locking portion 15A. Therefore, bent portions need only be formed in two areas and this saves time and effort for processing.

Further, although the electronic device case structure 10 is applied to the tower server device 25 in the exemplary embodiment, the electronic device case structure 10 is applicable not only to the tower server device 25 but also to general information devices.

The exemplary embodiment has been described taking an HDD as a vibration generating source. However, the present invention may also be applied to general devices including movable units such as a disk drive device other than an HDD or a cooling fan.

### (Supplementary note 1)

An electronic device case structure includes:
a unit case detachably mounted with an electronic device unit which holds inside, an electronic device acting as a vibration generating source; and
a unit support mechanism including a plurality of roller members implemented in a vibration-preventing member made of an elastic material, the roller members supporting the electronic device unit and guiding the electronic device unit in attaching and detaching the electronic device unit.

### (Supplementary note 2)

The case structure according to supplementary note 1, further includes a unit holding member which is formed in an opening portion formed in the top surface of the unit case and holds down a top surface of the electronic device unit mounted in the unit case.

### (Supplementary note 3)

The case structure according to supplementary note 2, wherein
the unit case includes a quadrangular frame-shaped cross-section defined by four surrounding faces, and
the roller members include four roller members mounted on each of three faces, excluding the top face, of the unit case to abut against each of three faces of the electronic device unit.

### (Supplementary note 4)

The case structure according to supplementary note 3, wherein the unit holding member includes a locking portion which engages with an engagement hole formed in the electronic device unit and locks the electronic device unit to prevent the electronic device unit as mounted in the unit case from moving in a direction of attachment and detachment.

### (Supplementary note 5)

The case structure according to supplementary note 4, wherein the roller members include two roller members mounted in each of a front area and a back area of each of the three faces of the unit case with a predetermined spacing therebetween in the direction of attachment and detachment.

### (Supplementary note 6)

The case structure according to supplementary note 5, wherein the predetermined spacing is equal to a distance between two nodes at which an amplitude of natural vibration of the electronic device unit is minimal when the electronic device unit is attached to the unit case.

### (Supplementary note 7)

The case structure according to supplementary note 6, further includes a pressing member mounted on a back surface of the unit holding member, the pressing member pressing the top surface of the electronic device unit.

### (Supplementary note 8)

The case structure according to supplementary note 7, wherein the holding member is removably mounted in the unit case.

### (Supplementary note 9)

The case structure according to supplementary note 8, wherein the electronic device unit is equipped with a plurality of hard disk drive devices.

This application claims the benefit of priority based on Japanese Patent Application No. 2013-048952 filed on March 12, 2013, the disclosure of which is hereby incorporated herein by reference in its entirety.

### [Industrial Applicability]

The electronic device case structure according to the present invention can be employed when an electronic device unit which holds an electronic device as a vibration generating source is attached not only to a tower server but also to general information devices.

### [Reference signs List]

- 10: case structure
- 11: unit case
- 12: bottom surface portion
- 13: side surface portion
- 14: top surface portion
- 14B: engagement hole
- 15: unit holding member
- 15A: locking portion
- 16: pressing member
- 18: unit support mechanism
- 19: roller member
- 30: electronic device unit
- 35: HDD

## Claims

1. An electronic device case structure comprising:
a unit case detachably mounted with an electronic device unit which holds inside, an electronic device acting as a vibration generating source; and
a unit support mechanism comprising a plurality of roller members implemented in a vibration-preventing member made of an elastic material, the roller members supporting the electronic device unit and guiding the electronic device unit in attaching and detaching the electronic device unit.

2. The case structure according to claim 1, further comprising a unit holding member which is formed in an opening portion formed in the top surface of the unit case and holds down a top surface of the electronic device unit mounted in the unit case.

3. The case structure according to claim 2, wherein
the unit case comprises a quadrangular frame-shaped cross-section defined by four surrounding faces, and
the roller members comprise four roller members mounted on each of three faces, excluding the top face, of the unit case to abut against each of three faces of the electronic device unit.

4. The case structure according to claim 3, wherein the unit holding member comprises a locking portion which engages with an engagement hole formed in the electronic device unit and locks the electronic device unit to prevent the electronic device unit as mounted in the unit case from moving in a direction of attachment and detachment.

5. The case structure according to claim 4, wherein the roller members comprise two roller members mounted in each of a front area and a back area of each of the three faces of the unit case with a predetermined spacing therebetween in the direction of attachment and detachment.

6. The case structure according to claim 5, wherein the predetermined spacing is equal to a distance between two nodes at which an amplitude of natural vibration of the electronic device unit is minimal when the electronic device unit is attached to the unit case.

7. The case structure according to claim 6, further comprising a pressing member mounted on a back surface of the unit holding member, the pressing member pressing the top surface of the electronic device unit.

8. The case structure according to claim 6, wherein the holding member is removably mounted in the unit case.

9. The case structure according to claim 8, wherein the electronic device unit is equipped with a plurality of hard disk drive devices.
